# EUROPEAN PATENT APPLICATION

(11) **EP 4 808 339 A1**
(43) Date of publication of application: **16.09.2026**
(21) Application number: 26161663.5
(22) Date of filing: 02.03.2026
(51) Int. Cl.: H10W 40/73, H10W 40/00, H10W 40/20, H10W 40/25

(54) **VAPOR CHAMBER FOR A HEAT DISSIPATION SUBSTRATE AND HEAT DISSIPATION SUBSTRATE FOR A POWER SEMICONDUCTOR MODULE INCLUDING THE SAME AND A MANUFACTURING METHOD THEREOF**

(30) Priority: 14.03.2025 KR 20250033113
(71) Applicant: LX Semicon Co., Ltd., Daejeon 34027 (KR)
(72) Inventor: RA, Se Woong, 34027 Daejeon (KR); KIM, Hak Jun, 34027 Daejeon (KR); LEE, Sang Rae, 34027 Daejeon (KR)
(74) Representative: Goddar, Heinz J.

(57) **Abstract**

A heat dissipation substrate vapor chamber according to an embodiment may include a frame part, a wick structure disposed inside the frame part; and a tube disposed on a side of the frame part. And the tube may include a first tube and a second tube.

## Description

### BACKGROUND

### Field of the Disclosure

The embodiment relates to a vapor chamber for a heat dissipation substrate and a heat dissipation substrate for a power semiconductor module including the same and a method for manufacturing the same.

### Description of the Background

A power conversion module is a device that performs power conversion (AC->DC, DC->AC), power transformation (step-down, step-up), power distribution, or power control functions.

The power conversion module is a core component that performs the function of improving energy efficiency in the process of transmitting and controlling power and controlling voltage changes to provide system stability and reliability, and is referred to as a power module or a power system.

A power conversion module includes various components such as a power semiconductor device, a heat dissipation substrate, a base plate, molding silicon, a case and cover, and a terminal.

Recently, eco-friendly cars based on electric or hydrogen are gaining attention instead of fossil fuel-based internal combustion engine cars, and these eco-friendly cars use numerous power semiconductor devices. Eco-friendly cars include hybrid electric vehicles (HEVs), plug-in hybrid electric vehicles (PHEVs), electric vehicles (EVs), and fuel cell electric vehicles (PCEVs).

In addition, power semiconductors are used in various electric and electronic devices such as electric vehicle chargers, energy storage devices, power supply devices, and railways in addition to eco-friendly cars.

Previously, silicon (Si) power semiconductor devices were widely used, but as Si power semiconductors reached their physical limits, research on WBG (Wide Bandgap) power semiconductors such as silicon carbide (SiC) or gallium nitride (GaN) to replace them is actively being conducted.

WBG power semiconductor devices have about three times the band gap energy of Si power semiconductor devices, about ten times the dielectric breakdown field of Si power semiconductor devices, and about three times higher thermal conductivity of Si power semiconductor devices. Due to these excellent characteristics, WBG power semiconductor devices can operate in high temperature and high voltage environments, and have the advantages of high switching speed and low switching loss.

For example, Si-based power semiconductor modules used to perform power conversion (DC↔AC), motor drive switching, and control in electric vehicles and hybrid electric vehicles were operated at a temperature environment of about 150°C, but recently, due to the demand for increased switching performance and power density, research is actively being conducted on wide band gap (WBG)-based power semiconductor devices such as SiC or GaN that can operate at an operating temperature of about 300°C or higher, for example, at about 300~700°C.

Meanwhile, the heat generated from the power semiconductor generates thermomechanical stress in each part of the power semiconductor module, and the life of the junction and power semiconductor devices may be deteriorated due to thermal fatigue at the junction. Therefore, the reliability design of the power semiconductor module that appropriately releases the heat generated from the power semiconductor device through the heat dissipation substrate and maintains the junction temperature of the power semiconductor device below an appropriate temperature is very important.

Meanwhile, the heat dissipation substrate for power semiconductors not only has the function of transmitting the heat generated during the operation of the power semiconductor device to the outside, but also has an important function of electrically connecting the power semiconductor devices by forming a circuit pattern on one side of the heat dissipation substrate.

However, recently, 1200V, 200A high-voltage/high-power SiC power conversion modules are being used for performance improvement of hybrid and electric vehicles and autonomous vehicles, and the operating temperature of power semiconductor devices during operation of these high-performance electric vehicles is required to be implemented at an average of 300°C or higher, and they are facing an ultra-high temperature usage state with an instantaneous maximum operating temperature of 350°C or higher.

In such an ultra-high temperature, high voltage, and high current operating environment, existing bonding materials themselves may be re-melted, and heat trapping phenomenon may occur due to pores existing in the bonding part, which may rapidly deteriorate the life of the power semiconductor module. For example, cracks may occur due to defects induced at the interface between the ceramic substrate of the heat dissipation substrate and the copper (Cu) sheet, and cracks induced in such a heat dissipation substrate may cause thermal runaway, leading to the destruction of the power semiconductor device.

Accordingly, a structure such as a vapor chamber or a heat sink is disposed on one side of the heat dissipation substrate to improve the heat dissipation performance of the heat dissipation substrate.

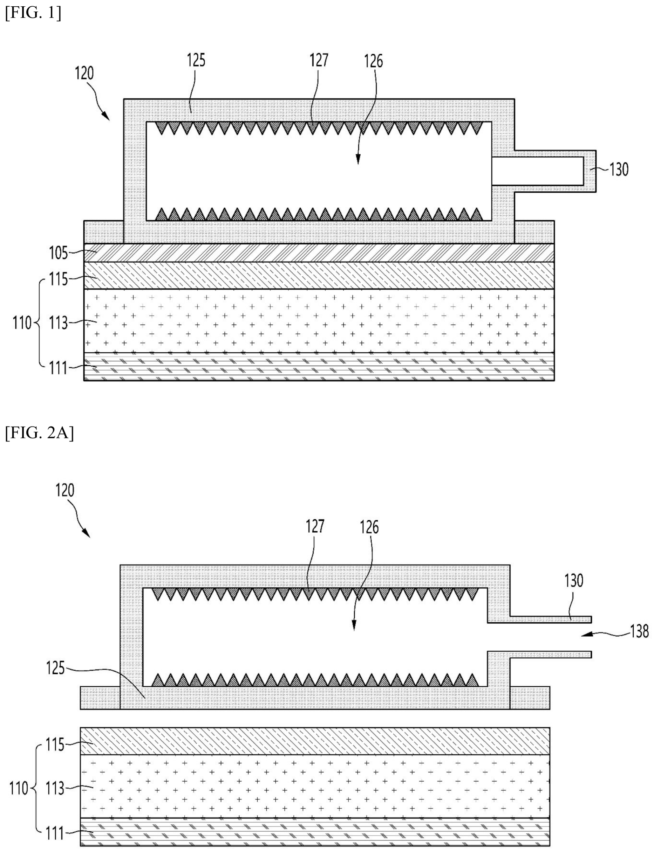

For example, FIG. 1 is a conceptual drawing of a heat dissipation substrate including a conventional vapor chamber. Referring to FIG. 1, the vapor chamber (120) includes a frame part (125), a hollow structure (126), a wick structure (127), and a tube (130), and a process of injecting a working fluid into the vapor chamber (120) through the tube (130), sealing the tube (130), and bonding it to the heat dissipation substrate (110) can be performed.

At this time, the process of bonding the heat dissipation substrate (110) and the vapor chamber (120) with the adhesive layer (105) is performed at a temperature of about 150°C or less to prevent damage due to expansion of the sealed vapor chamber (120).

For example, an adhesive layer (105) such as a thermal adhesive made of polymer or a solder used in a low-temperature process is placed between the vapor chamber (120) and the heat dissipation substrate (110). Meanwhile, the adhesive layer (105) used in the low-temperature process has low thermal conductivity, so that heat is not transferred smoothly from the heat dissipation substrate (110) to the vapor chamber (120), which reduces the heat dissipation performance. And there is a problem that the bonding reliability of the vapor chamber (120) and the heat dissipation substrate (110) is reduced due to the swollen phenomenon of the adhesive layer (105) or the unevenness of the surface.

Accordingly, research is needed to improve the thermal conductivity between the heat dissipation substrate and the vapor chamber and improve the bonding reliability while preventing damage due to the expansion of the vapor chamber (120).

Meanwhile, in order to improve the thermal conductivity between the heat dissipation substrate and the vapor chamber, a case of using a bonding layer used in a high-temperature process of about 200°C or higher with high thermal conductivity may be considered. First, a process is performed in which a vapor chamber without fluid injection is bonded to a heat dissipation substrate, then a working fluid is injected into the vapor chamber (120) through a tube (130), and then the tube (130) is sealed. In this case, since the vapor chamber may be not sealed during high-temperature bonding, a problem occurs in which the wick structure (127) inside the vapor chamber (120) is oxidized.

### SUMMARY

Accordingly, the present disclosure is directed to a vapor chamber for a heat dissipation substrate and a heat dissipation substrate for a power semiconductor module including the same and a method for manufacturing the same that substantially obviates one or more of problems due to limitations and disadvantages described above.

One of the technical objects of the embodiment is to improve the heat transferability between the vapor chamber and the heat dissipation substrate. In addition, one of the technical objects of the embodiment is to improve the bonding reliability of the vapor chamber and the heat dissipation substrate.

In addition, one of the technical objects of the embodiment is to prevent damage due to expansion of the vapor chamber (120).

In addition, one of the technical objects of the embodiment is to prevent the problem of the wick structure (127) inside the vapor chamber (120) from being oxidized even when the bonding temperature of the heat dissipation substrate and the vapor chamber is performed at a high temperature of about 200°C or higher.

The technical objects of the embodiment are not limited to what is described in this item and include what can be understood through the description of the invention.

A vapor for the heat dissipation substrate according to the embodiment may include a chamber frame part, a wick structure disposed inside the frame part, and a tube disposed on a side of the frame part. And the tube may include a first tube and a second tube.

In addition, in the embodiment, the first tube and the second tube may be disposed on different sides of the frame part. In addition, the first tube and the second tube may be disposed on the same side of the frame part.

In addition, in the embodiment, the first tube and the second tube may be disposed at different heights. The first tube and the second tube may be vertically overlapped with each other.

In addition, in the embodiment, the second tube may include a plurality of tubes.

In addition, in the embodiment, the first tube may include a first thickness in an area adjacent to the outside of the frame part and a second thickness in an area adjacent to the inside of the frame part. The first thickness may be different from the second thickness. The first thickness may be thinner than the second thickness.

In addition, in the embodiment, the frame part may include a curved portion on the inside. The curved portion may be connected to the second tube.

In addition, the heat dissipation substrate for the power semiconductor module according to the embodiment may include an insulating substrate, an upper metal plate disposed on the insulating substrate, a lower metal plate disposed under the insulating substrate, and a vapor chamber disposed on the upper metal plate. And the vapor chamber may include any one of the vapor chambers for the heat dissipation substrate as above.

In addition, in the embodiment, the upper metal plate and the vapor chamber may be in direct contact.

In the embodiment, a metal bonding layer may be disposed between the upper metal plate and the vapor chamber.

In addition, the embodiment may include a solder layer disposed between the upper metal plate and the vapor chamber, and the solder layer may include tin (Sn).

In addition, the method for manufacturing a heat dissipation substrate for a power semiconductor module according to the embodiment may include a step of preparing a heat dissipation substrate, a step of preparing an unsealed vapor chamber, a step of bonding the heat dissipation substrate and the vapor chamber at a temperature of 200° C. or higher, a step of injecting a working fluid into the vapor chamber, and a step of sealing the vapor chamber. The vapor chamber may include a frame part, a wick structure disposed inside the frame part, and a tube disposed on a side surface of the frame part. The tube may include a first tube and a second tube.

Any one, some or all of the features described with respect to the vapor chamber and/or the heat dissipation substrate as disclosed herein may be implemented in the manufacturing method, unless indicated otherwise or technically inappropriate. Any one, some or all of the features described with respect to manufacturing method as disclosed herein may be implemented in the vapor chamber and/or the heat dissipation substrate, unless indicated otherwise or technically inappropriate.

The vapor chamber for a heat dissipation substrate according to the embodiment has a technical effect of improving heat transfer between heat dissipation substrates.

For example, in the embodiment, when the vapor chamber may be not sealed and high-temperature bonding may be performed with the heat dissipation substrate, the vapor chamber and the heat dissipation substrate may be in direct contact or may have an adhesive layer having high heat dissipation properties, so that the heat transfer between the vapor chamber and the heat dissipation substrate can be improved.

In addition, the embodiment has a technical effect that can effectively discharge vaporized organic substances generated during the high-temperature bonding process between the vapor chamber and the heat dissipation substrate, thereby improving the heat dissipation performance of the vapor chamber.

For example, in the embodiment, when the unsealed vapor chamber and the heat dissipation substrate may be bonded at a high temperature of about 200°C or higher, the problem of the wick structure being oxidized by the surface-treated organic substance in the wick structure inside the vapor chamber can be prevented, and the surface-treated organic substance can be effectively discharged through the fill tube and the dummy tube. Accordingly, the embodiment has a special technical effect that can prevent oxidation of the wick structure and simultaneously improve the heat dissipation performance of the vapor chamber by actively promoting the vaporization and condensation phenomenon of the working fluid even when the vapor chamber and the heat dissipation substrate may be bonded at a high temperature of about 200°C or higher.

In addition, the embodiment has a technical effect that can improve the bonding reliability of the vapor chamber and the heat dissipation substrate.

The technical effects of the embodiment are not limited to what is described in this item and includes what can be understood through the description of the invention.

### BRIEF DESCRIPTION OF THE DRAWINGS

The accompanying drawings, which are included to provide a further understanding of the disclosure and are incorporated in and constitute a part of the disclosure, illustrate aspects of the disclosure and together with the description serve to explain the principle of the disclosure.
In the drawings: FIG. 1 is a conceptual drawing of a heat dissipation substrate including a conventional vapor chamber.
FIGS. 2A to 2C are manufacturing process drawings of a vapor chamber for a heat dissipation substrate for a power semiconductor module according to the embodiment.
FIG. 3 is a cross-sectional view of a vapor chamber for a heat dissipation substrate according to the second embodiment.
FIG. 4 is a cross-sectional view of a vapor chamber for a heat dissipation substrate according to the third embodiment.
FIG. 5 is a cross-sectional view of a vapor chamber for a heat dissipation substrate according to the fourth embodiment.
FIG. 6 is a cross-sectional view of a vapor chamber for a heat dissipation substrate according to the fifth embodiment.

### DETAILED DESCRIPTION

Hereinafter, the aspects disclosed in this specification will be described in detail with reference to the attached drawings. The suffixes 'module' and 'part' used for elements in the following description are given or used interchangeably in consideration of the ease of writing the specification, and do not have distinct meanings or roles in themselves. In addition, the attached drawings are intended to facilitate easy understanding of the aspects disclosed in this specification, and the technical ideas disclosed in this specification are not limited by the attached drawings. In addition, when an element such as a layer, region, or substrate is mentioned as existing 'on' another element, this includes that it may be directly on the other element, or that other intermediate elements may exist in between.

The suffixes "module" and "part" used for components in the following description are given simply for the convenience of writing this specification, and do not themselves give a particularly important meaning or role. Therefore, the "module" and "part" may be used interchangeably.

Terms including ordinal numbers such as first, second, etc. may be used to describe various components, but the components are not limited by the terms. The terms are used only for the purpose of distinguishing one component from another component.

The singular expression includes the plural expression unless the context clearly indicates otherwise.

In the present application, the terms "includes," or "has" are intended to specify the presence of a feature, number, step, operation, component, part, or combination thereof described in the specification, and should be understood as not excluding in advance the possibility of the presence or addition of one or more other features, numbers, steps, operations, components, parts, or combinations thereof.

In addition, the heat dissipation substrate for power semiconductors according to the embodiment may be mounted and used in power semiconductor modules used in inverters or converters for automobiles, computers, home appliances, solar power, smart grids, etc. In addition, the heat dissipation substrate for power semiconductors according to the embodiment may be mounted and used in power semiconductor modules mounted in various electric and electronic devices such as electric vehicle chargers, power supply devices, or railways in addition to eco-friendly automobiles.

### (Example)

FIGS. 2A to 2C are manufacturing process drawings of a vapor chamber for a heat dissipation substrate for power semiconductor modules according to the embodiment. Hereinafter, 'vapor chamber for the heat dissipation substrate for the power semiconductor module' may be abbreviated as 'vapor chamber for the heat dissipation substrate ' or 'vapor chamber'.

Referring to FIG. 2A, the embodiment may include a heat dissipation substrate (110) and a vapor chamber (120).

The heat dissipation substrate (110) may include a lower metal plate (111), an insulating substrate (113), and an upper metal plate (115). The insulating substrate (113) may electrically insulate the lower metal plate (111) and the upper metal plate (115). The insulating substrate (113) may include a polycrystalline insulating substrate made of a ceramic material having high thermal conductivity. For example, the insulating substrate (113) may be one of AlN or Si₃N₄, but is not limited thereto, and may also be Al₂O₃, etc. In addition, the insulating substrate (113) may include a single crystal substrate such as a sapphire substrate. The insulating substrate (113) is described as a polycrystalline substrate made of ceramic material as an example, but is not limited thereto, and may also include a single-crystal substrate.

In addition, a lower metal plate (111) may be disposed on the lower surface of the insulating substrate (113), and an upper metal plate (115) may be disposed on the upper surface. The lower metal plate (111) and the upper metal plate (115) may include a Cu-based metal, but are not limited thereto.

In addition, the vapor chamber (120) may include a frame part (125), a hollow structure (126), a wick structure (127), and a tube (130). The frame part (125) may include a metal material, and may include, for example, copper (Cu). In addition, the frame part (125) may have an empty interior, that is, a hollow structure (126). In addition, a tube (130) may be formed on one surface of the frame part (125). The tube (130) may include an opening (138).

In addition, the wick structure (127) may be formed on the inner surface of the frame part (125) inside the vapor chamber (120). The wick structure (127) may cause a capillary phenomenon by the surface tension of the liquid to return the liquid-state working fluid from the condenser to the evaporator, and may include a capillary structure. In addition, the wick structure (127) may have a mesh shape or a groove shape, but is not limited thereto. In addition, the wick structure (127) may utilize electromagnetic force, centrifugal force, osmotic pressure, or gravity, but is not limited thereto, in addition to the capillary phenomenon.

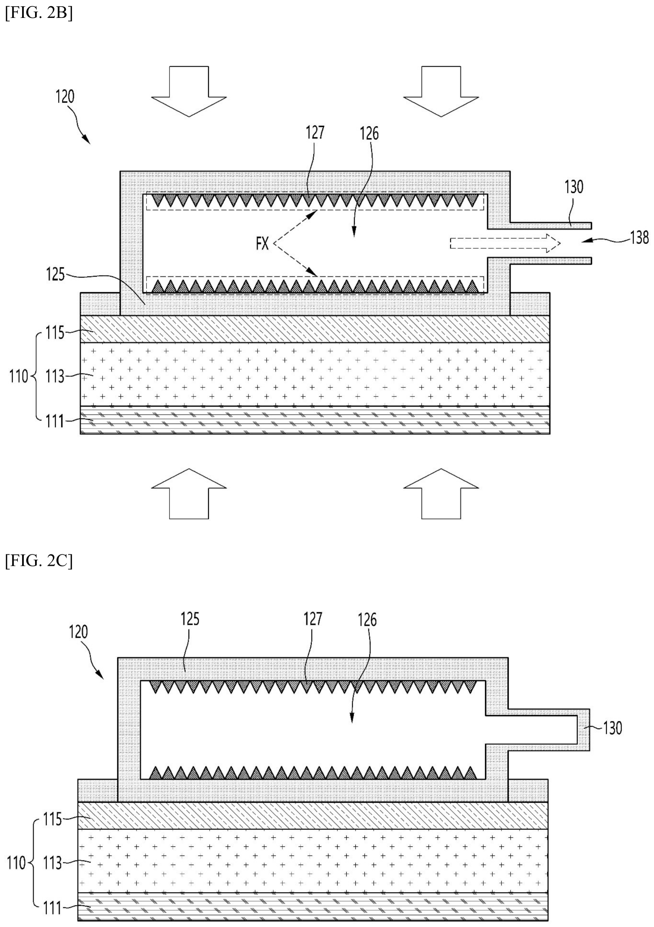

Referring to FIG. 2B, the embodiment may be bonded to the heat dissipation substrate (110) in a state in which the working fluid is not injected into the vapor chamber (120), that is, in a state in which the inside of the vapor chamber may be not sealed. For example, the opening (138) of the vapor chamber tube (130) may be bonded to the heat dissipation substrate (110) in an unsealed state.

According to an embodiment, a high-temperature bonding process can be performed in an unsealed state of the vapor chamber (120). The high-temperature bonding process may include a process of 200° C. or higher. For example, the upper metal plate (115) of the heat dissipation substrate (110) and the frame of the vapor chamber (120) may be metallic bonded, and for example, the metal bonding can be Cu to Cu bonding, but is not limited thereto.

Therefore, the embodiment can perform bonding so that the vapor chamber (120) and the heat dissipation substrate (110) come into direct contact at a high temperature of 200° C. or higher without a separate low-temperature process solder or thermal interface material. Accordingly, the embodiment has a technical effect that the vapor chamber (120) and the heat dissipation substrate (110) can be bonded without a heat transfer material, thereby preventing the vapor chamber (120) and the heat dissipation substrate (110) from being separated, and improving the heat transfer performance.

Alternatively, the embodiment may perform a bonding process by using a high-temperature process solder containing a high-heat dissipation metal thermal interface material such as AlSiC, Al, Cu, etc., or tin (Sn), which has high heat dissipation performance, through a high-temperature bonding process of 200°C or higher.

Accordingly, the embodiment can significantly improve the bonding strength by a high-temperature bonding process of 200°C or higher, and can improve the heat transfer performance between the heat dissipation substrate (110) and the vapor chamber (120). In addition, the embodiment has a technical effect that the alignment or positional precision of the heat dissipation substrate (110) and the vapor chamber (120) can be further improved as the heat transfer material or solder is reflowed by the high-temperature bonding process.

Meanwhile, in the embodiment, in order to prevent oxidation of the wick structure (127) disposed inside the vapor chamber (120) when the vapor chamber (120) is bonded at high temperature without being sealed, surface treatment (FX) may be performed on the surface of the wick structure (127). The surface treatment may use an organic material, etc., and may be referred to as a 'flux'. In the embodiment, the anti-oxidation material on the structure (127) may include, but is not limited to, an inorganic flux such as zinc chloride, an organic flux such as hydrochloride, a rosin flux, a water-soluble flux such as salt, or an acid.

Meanwhile, in the embodiment, during the process of high-temperature bonding of the vapor chamber (120) and the heat dissipation substrate (110), the material treated on the surface of the wick structure (127) may evaporate and be released to the outside through the opening (138) of the tube (130). On the other hand, although some of the material used for surface treatment may remain in the wick structure (127), it may evaporate to a level that does not affect the performance of the vapor chamber. If there is a flux inside the vapor chamber, this may be evidence of utilizing the technical features of this invention.

Next, referring to FIG. 2C, in the embodiment, after the vapor chamber (120) and the heat dissipation substrate (110) may be bonded, the working fluid may be injected into the hollow structure (126) through the tube (130). The working fluid may be, but is not limited to, acetone, methanol, ethanol, or ultrapure water (DI-water). After the working fluid is injected, the opening of the tube (130) can be sealed to seal the entire inside of the vapor chamber (120).

In the embodiment, as the heat generated from the electronic component (not shown) is transferred to the frame part (125) of the vapor chamber (120), the working fluid vaporizes, absorbs the latent heat of vaporization, and moves upward to condense, releasing the latent heat of vaporization, thereby being condensed into a liquid.

Accordingly, the embodiment has a technical effect that the thermal conductivity of the vapor chamber (120) and the heat dissipation substrate (110) can be improved by metal bonding or high-temperature bonding, and the heat dissipation performance of the heat dissipation substrate (110) can be improved.

In addition, the embodiment has a technical effect that the vapor chamber (120) and the heat dissipation substrate (110) are bonded by high-temperature metal bonding rather than a low-temperature thermal adhesive layer including low-temperature solder or polymer, so that the bonding interface can be uniform and the creeping phenomenon can be reduced, and the bonding reliability and positional precision of the vapor chamber (120) and the heat dissipation substrate (110) can be improved.

In addition, the embodiment performs high-temperature bonding in a state where the vapor chamber (120) may be not sealed, and in order to prevent oxidation of the wick structure (127) placed inside the vapor chamber (120), the surface of the wick structure (127) may be surface-treated with an anti-oxidation layer.

At this time, according to the embodiment, during the process of high-temperature bonding of the vapor chamber (120) and the heat dissipation substrate (110), the anti-oxidation layer material treated on the surface of the wick structure (127) may evaporate and be released to the outside.

Meanwhile, the anti-oxidation layer material used for surface treatment may remain in the wick structure (127), but it is important to have a technology to effectively discharge the anti-oxidation layer material remaining inside the vapor chamber (120) to a level that does not affect the performance of the vapor chamber, and the features of the embodiment for implementing this technical effect will be described in detail.

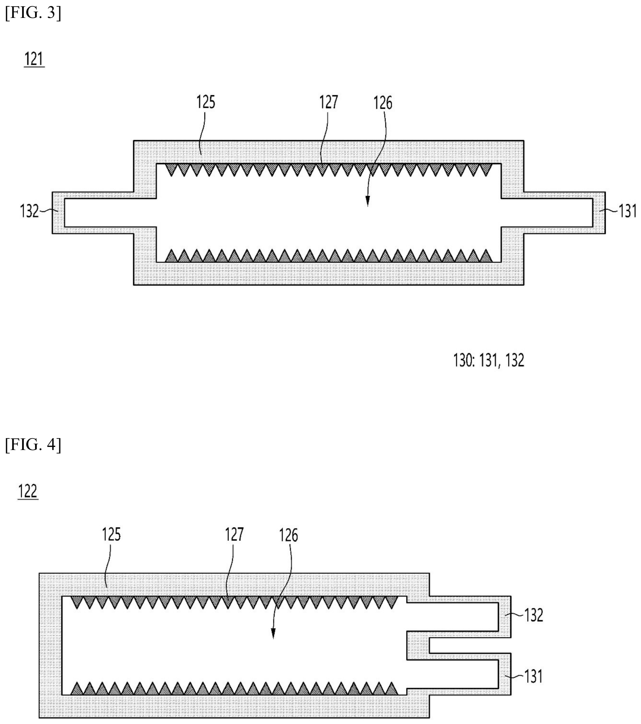

FIG. 3 is a cross-sectional view of a vapor chamber (121) for a heat dissipation substrate according to the second embodiment. Referring to FIG. 3, the second embodiment may include a tube (130) disposed on one side of the frame part (125).

The tube (130) may not only function to inject a working fluid into the vapor chamber (121), but also function as a passage for discharging organic substances present in the hollow structure (126) after a high-temperature bonding process between the vapor chamber (121) and the heat dissipation substrate (not shown).

Accordingly, in the embodiment, the tube (130) may include a plurality of tubes, and when a plurality of tubes (130) are provided, there is a technical effect of more effectively discharging organic substances generated as the vapor chamber is bonded to the heat dissipation substrate at high temperatures than when there is only one tube.

The tube (130) may include a first tube (131) and a second tube (132). For example, the first tube (131) may be a fill tube into which the working fluid is injected, and the second tube (132) may be a dummy tube for discharging the anti-oxidation layer material. Of course, the first tube (131) may also function to discharge the anti-oxidation layer material.

The first tube (131) may be disposed on one side of the frame part (125). In addition, the second tube (132) may be disposed on the other side of the frame part (125). The first tube (131) and the second tube (132) may be disposed on opposite sides. Or the first tube (131) and the second tube (132) may be disposed on the same side surface. In addition, the second embodiment may further include a plurality of tubes.

In addition, the embodiment can discharge organic substances existing in the hollow structure (126) through the first tube (131) and the second tube (132) after high-temperature bonding of the vapor chamber (121) and the heat dissipation substrate (not shown), and then inject the working fluid through the first tube (131) and seal the first tube (131) and the second tube (132). At this time, a small amount of organic substances, etc. may remain on the surface of the wick structure (127) to the extent that it does not cause a decrease in heat-radiating performance, but is not limited thereto.

In the drawing, the first tube (131) and the second tube (132) are shown as protruding into the frame part (125) and having a space inside, but they may have a compressed form when sealed.

Accordingly, the embodiment has a plurality of tubes (130) disposed in the frame part (125), and can effectively discharge organic substances generated when the vapor chamber is bonded to the heat dissipation substrate at high temperature through the plurality of tubes (130) in an unsealed state, and can improve the vaporization and condensation phenomenon of the working fluid by the wick structure (127), thereby improving the heat dissipation performance of the vapor chamber.

FIG. 4 is a cross-sectional view of a vapor chamber (122) for a heat dissipation substrate according to the third embodiment. Referring to FIG. 4, a first tube (131) and a second tube (132) may be disposed on the same surface of the frame part (125). At this time, the second tube (132) may be disposed higher than the first tube (131). The upper surface of the second tube (132) may be positioned higher than the upper surface of the first tube (131). The second tube (132) and the first tube (131) may overlap in the vertical direction, but are not limited thereto.

At least one of the first tube (131) and the second tube (132) may be a fill tube into which a working fluid is injected, and at least one may be a dummy tube.

In addition, although the third embodiment is illustrated in the drawing as having the first tube (131) and the second tube (132) disposed on the same side of the frame part (125), the first tube (131) and the second tube (132) may be disposed on different sides of the frame part (125), and the second tube (132) may be positioned higher than the first tube (131).

Meanwhile, the anti-oxidation layer material surface-treated on the wick structure (127) may exist in a form mixed with air within the hollow structure (126) when the vapor chamber (122) is vaporized after high-temperature bonding with the ceramic substrate. At this time, if the vaporized material is heavier than air, the second tube (132) may function as a dummy tube, and the first tube (131) may function as a fill tube.

In addition, if the vaporized material is lighter than air, the first tube (131) may function as a dummy tube, and the second tube (132) may function as a fill tube.

Accordingly, the third embodiment has a special technical effect of effectively discharging vaporized organic materials by forming the heights of the first tube (131) and the second tube (132) differently from each other.

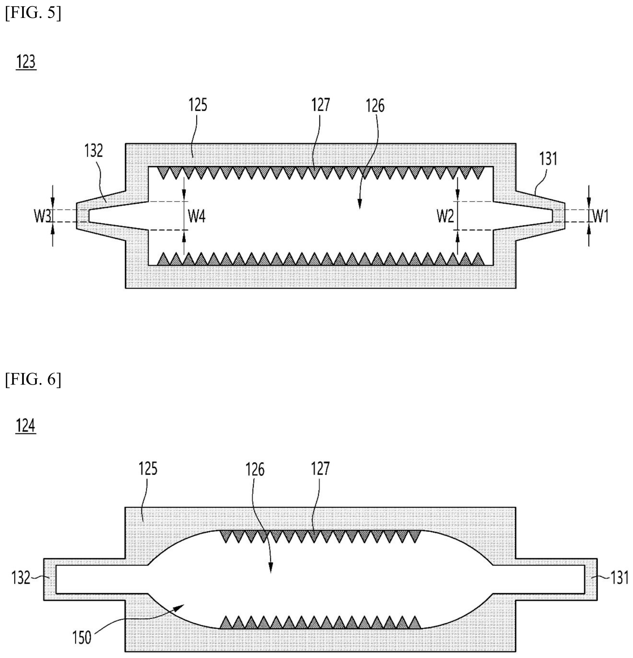

FIG. 5 is a cross-sectional view of a vapor chamber (123) for a heat dissipation substrate according to the fourth embodiment. Referring to FIG. 5, the vapor chamber (123) of the fourth embodiment may include a first tube (131) and a second tube (132). Meanwhile, since the fourth embodiment is provided with a fill tube and a dummy tube separately to discharge vaporized organic substances within the hollow structure (126) as well as to inject a working fluid into the vapor chamber (123), the first tube (131) and the second tube (132) may have different thicknesses along the length direction.

For example, the first tube (131) may include a first thickness (W1) in a region adjacent to the injection port and a second thickness (W2) adjacent to the hollow structure. At this time, the first thickness (W1) of the first tube (131) may be smaller than the second thickness (W2).

In addition, the second tube (132) may include a third thickness (W3) in an area adjacent to the discharge port and a fourth thickness (W4) adjacent to the hollow structure. The third thickness (W3) of the second tube (132) may be smaller than the fourth thickness (W4).

In addition, although the first tube (131) and the second tube (132) are illustrated in FIG. 5 as having the same shape, in the fourth embodiment, the third thickness (W3) of the second tube (132) may be larger than the first thickness (W1) of the first tube (131). In this case, there is a technical effect that the discharge of vaporized organic substances can be improved, the activity of the vaporization and condensation phenomena of the working fluid can be improved, and the heat dissipation performance of the vapor chamber can be improved.

FIG. 6 is a cross-sectional view of a vapor chamber (124) for a heat dissipation substrate according to the fifth embodiment. Referring to FIG. 6, the vapor chamber (124) of the fifth embodiment may further include a curved portion (150) inside the frame part (125). The curved portion (150) may be provided in an area extending from the inner wall of the frame part (125) to the first tube (131) or the second tube (132). Accordingly, the embodiment may not have an area having an acute angle or a right angle inside the vapor chamber (124).

In addition, a wick structure (127) may be disposed on the inner surface of the frame part (125). The wick structure (127) may be disposed in a flat area inside the frame part (125) and may not be disposed in the curved portion (150), but is not limited thereto.

Accordingly, the fifth embodiment has a special technical effect that organic substances vaporized when the vapor chamber (124) is bonded at high temperature with a ceramic substrate (not shown) in an unsealed state can be effectively discharged along the curved portion (150).

Therefore, the fifth embodiment has a special technical effect that, since the wick structure (127) is surface-treated with an anti-oxidation layer material, it prevents oxidation of the wick structure (127) before the vapor chamber (124) is sealed, and at the same time, minimizes organic substances remaining in the wick structure (127) during high-temperature bonding, thereby activating the vaporization and condensation phenomenon of the working fluid by the wick structure (127), thereby significantly improving the heat dissipation performance of the vapor chamber.

Although the above has been described with reference to the embodiments of the present invention, those skilled in the art will easily understand that the present invention can be variously modified and changed within the scope of the invention described in the following patent claims.

### [Reference signs]

| | | | | |
|---|---|---|---|---|
| [98] | 110: | heat dissipation substrate | 111: | Lower metal plate |
| [99] | 113: | insulating substrate | 115: | Upper metal plate |
| [100] | 120: | Vapor chamber | 125: | Frame part |
| [101] | 126: | Hollow structure | 127: | Wick structure |
| [102] | FX: | surface treatment | 130: | Tube |
| [103] | 131: | First tube | 132: | Second tube |
| [104] | 138: | Opening | 150: | Curved part |

## Claims

1. A vapor chamber for a heat dissipation substrate, the vapor chamber comprising:
a frame part;
a wick structure disposed inside the frame part; and
a tube disposed on a side surface of the frame part,
wherein the tube comprises a first tube and a second tube,

2. The vapor chamber according to the claim 1, wherein the first tube and the second tube are disposed on different sides of the frame part.

3. The vapor chamber according to the claim 1, wherein the first tube and the second tube are disposed on the same side of the frame part.

4. The vapor chamber according to the claim 1, wherein the first tube and the second tube are disposed at different heights.

5. The vapor chamber according to the claim 2 or claim 3, wherein the first tube and the second tube are vertically overlapped with each other.

6. The vapor chamber according to any one of the claims 1 to 5, wherein the second tube is provided in multiple pieces.

7. The vapor chamber according to any one of the claims 1 to 6, wherein the first tube comprises a first thickness in a region adjacent to an outer side of the frame part and a second thickness in a region adjacent to an inner side of the frame part, and
wherein the first thickness is different from the second thickness.

8. The vapor chamber according to the claim 7, wherein the first thickness is thinner than the second thickness.

9. The vapor chamber according to any one of the claims 1 to 8, wherein the frame part comprises a curved portion on an inner side.

10. The vapor chamber according to the claim 9, wherein the curved portion is connected to the second tube.

11. A heat dissipation substrate for a power semiconductor module, the heat dissipation substrate comprising:
an insulating substrate;
an upper metal plate disposed on the insulating substrate;
a lower metal plate disposed under the insulating substrate; and
a vapor chamber disposed on the upper metal plate,
wherein the vapor chamber comprises any one of the vapor chambers according to any one of the claims 1 to 10.

12. The heat dissipation substrate according to the claim 11, wherein the upper metal plate and the vapor chamber is in direct contact each other and
further comprising a metal bonding agent disposed between the upper metal plate and the vapor chamber.

13. The heat dissipation substrate according to the claim 11, further comprising a solder layer disposed between the upper metal plate and the vapor chamber, and
wherein the solder layer comprises Sn.

14. A method for manufacturing a heat dissipation substrate for a power semiconductor module, the method comprising:
preparing a heat dissipation substrate;
preparing an unsealed vapor chamber;
bonding the heat dissipation substrate and the vapor chamber at a temperature of 200° C. or higher;
injecting a working fluid into the vapor chamber; and
sealing the vapor chamber after the injecting the working fluid.

15. The method according to the claim 14, wherein the vapor chamber comprises any one of the vapor chambers according to any one of the claims 1 to 10.
